# EUROPEAN PATENT APPLICATION

(11) **EP 2 383 792 A2**
(43) Date of publication of application: **02.11.2011**
(21) Application number: 11163496.0
(22) Date of filing: 21.04.2011
(51) Int. Cl.: H01L 31/0296, H01L 31/18, H01L 31/072

(54) **Cadmium Sulfide Layers for Use in Cadmium Telluride Based Thin Film Photovoltaic Devices and Methods of their Manufacture**

(30) Priority: 29.04.2010 US 770055
(71) Applicant: PrimeStar Solar, Inc, Arvada, CO 80004 (US)
(72) Inventor: Drayton, Jennifer Ann, Arvada, CO 80004 (US); Peabody, Scott Daniel-Feldman, Arvada, CO 80004 (US); Gossman, Robert Dwayne, Arvada, CO 80004 (US)
(74) Representative: Szary, Anne Catherine

(57) **Abstract**

Cadmium telluride thin film photovoltaic devices 10 are generally provided. The device 10 can include a substrate 12, a transparent conductive oxide layer 14 on the substrate 12; a resistive transparent buffer layer 16 on the transparent conductive oxide layer 14; a cadmium sulfide layer 18 on the resistive transparent buffer layer 16; a cadmium telluride layer 20 on the cadmium sulfide layer 18; and, a back contact layer 22 on the cadmium telluride layer 20. The cadmium sulfide layer 18 can include oxygen in a molar percentage greater than 0 % to about 20 %. In one particular embodiment, a second cadmium sulfide layer 19 substantially free from oxygen can be positioned between the cadmium sulfide layer 18 and the cadmium telluride layer 20.

Methods of depositing a cadmium sulfide layer 18 on a substrate 12 and methods of manufacturing a cadmium telluride thin film photovoltaic device 10 are also generally provided.

## Description

### FIELD OF THE INVENTION

The subject matter disclosed herein relates generally to cadmium sulfide thin film layers and their methods of deposition. More particularly, the subject matter disclosed herein relates to cadmium sulfide layers for use in cadmium telluride thin film photovoltaic devices and their methods of manufacture.

### BACKGROUND OF THE INVENTION

Thin film photovoltaic (PV) modules (also referred to as "solar panels") based on cadmium telluride (CdTe) paired with cadmium sulfide (CdS) as the photo-reactive components are gaining wide acceptance and interest in the industry. CdTe is a semiconductor material having characteristics particularly suited for conversion of solar energy to electricity. For example, CdTe has an energy bandgap of about 1.45 eV, which enables it to convert more energy from the solar spectrum as compared to lower bandgap semiconductor materials historically used in solar cell applications (e.g., about 1.1 eV for silicon). Also, CdTe converts radiation energy in lower or diffuse light conditions as compared to the lower bandgap materials and, thus, has a longer effective conversion time over the course of a day or in cloudy conditions as compared to other conventional materials. The junction of the n-type layer and the p-type layer is generally responsible for the generation of electric potential and electric current when the CdTe PV module is exposed to light energy, such as sunlight. Specifically, the cadmium telluride (CdTe) layer and the cadmium sulfide (CdS) form a p-n heterojunction, where the CdTe layer acts as a p-type layer (i.e., a positive, electron accepting layer) and the CdS layer acts as a n-type layer (i.e., a negative, electron donating layer).

The cadmium sulfide layer is a "window layer" in the photovoltaic device since light energy passes through it into the cadmium telluride layer. However, the optical bandgap of cadmium sulfide of about 2.42 eV limits the amount of radiation that can pass through the cadmium sulfide layer in the blue through ultraviolet. Thus, the radiation reaching the cadmium telluride layer is reduced in the higher energy region, resulting in otherwise available radiation energy being absorbed and/or reflected instead of converting to electrical current in the cadmium telluride layer.

As such, a need exists for shifting and/or expanding the optical bandgap of the cadmium sulfide layer, especially in the higher energy region (e.g., the blue to ultraviolet wavelengths), in order to increase the output of a cadmium telluride based thin film photovoltaic device.

### BRIEF DESCRIPTION OF THE INVENTION

Aspects and advantages of the invention will be set forth in part in the following description, or may be obvious from the description, or may be learned through practice of the invention.

Cadmium telluride thin film photovoltaic devices are generally provided. In one embodiment, the device can include a substrate, a transparent conductive oxide layer on the substrate; a resistive transparent buffer layer on the transparent conductive oxide layer; a cadmium sulfide layer on the resistive transparent buffer layer; a cadmium telluride layer on the cadmium sulfide layer; and, a back contact layer on the cadmium telluride layer. The cadmium sulfide layer can include oxygen in a molar percentage greater than 0 % to about 20 %. In one particular embodiment, a second cadmium sulfide layer substantially free from oxygen can be positioned between the cadmium sulfide layer and the cadmium telluride layer.

Methods of depositing a cadmium sulfide layer on a substrate are also generally provided. For example, a cadmium sulfide layer can be sputtered on a substrate from a target of cadmium sulfide in a sputtering atmosphere including an inert gas and oxygen in an amount of greater than 0% to about 20% by volume. In one particular embodiment, a second cadmium sulfide layer can be sputtered on the cadmium sulfide layer in a second sputtering atmosphere that is substantially free from oxygen.

Methods of manufacturing a cadmium telluride thin film photovoltaic device are also generally provided. In one embodiment, a resistive transparent buffer layer can be deposited on a transparent conductive oxide layer. A cadmium sulfide layer can be sputtered on the resistive transparent buffer layer from a target of cadmium sulfide in a sputtering atmosphere including an inert gas and oxygen in an amount of greater than 0% to about 20% by volume. A cadmium telluride layer can be deposited on the on the cadmium sulfide layer.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWING

A full and enabling disclosure of the present invention, including the best mode thereof, directed to one of ordinary skill in the art, is set forth in the specification, which makes reference to the appended figures, in which:
Fig. 1 shows a general schematic of a cross-sectional view of an exemplary cadmium telluride thin film photovoltaic device according to one embodiment of the present invention;
Fig. 2 shows a general schematic of a cross-sectional view of an exemplary cadmium telluride thin film photovoltaic device according to one embodiment of the present invention;

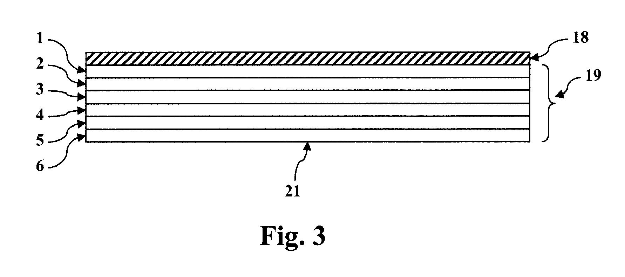

Fig. 3 shows a general schematic of a cross-sectional view of an exemplary cadmium sulfide layer and a second cadmium sulfide layer formed by a plurality of graded layers;
Fig. 4 shows a general schematic of a cross-sectional view of an exemplary DC sputtering chamber according to one embodiment of the present invention; and,
Fig. 5 shows a flow diagram of an exemplary method of manufacturing a photovoltaic module including a cadmium telluride thin film photovoltaic device.

Repeat use of reference characters in the present specification and drawings is intended to represent the same or analogous features or elements.

### DETAILED DESCRIPTION OF THE INVENTION

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

In the present disclosure, when a layer is being described as "on" or "over" another layer or substrate, it is to be understood that the layers can either be directly contacting each other or have another layer or feature between the layers. Thus, these terms are simply describing the relative position of the layers to each other and do not necessarily mean "on top of" since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

Generally speaking, devices and methods are disclosed for cadmium sulfide layers including oxygen (e.g., oxygen doped cadmium sulfide layers), particularly those cadmium sulfide layers included in a cadmium telluride based thin film device. Including oxygen in the cadmium sulfide layer can cause the optical bandgap to shift to include higher energy radiation (such as blue and ultraviolet radiation). Thus, a cadmium sulfide layer including oxygen can allow more light to enter the cadmium telluride layer for conversion to electrical current, resulting in a more efficient photovoltaic device.

The addition of oxygen to the cadmium sulfide layer may result in the formation of cadmium oxide (CdO) within the structure of the cadmium sulfide layer. The amount of oxygen included in the cadmium sulfide layer can be varied according to the desired optical bandgap shift. In most embodiments, the molar percentage of oxygen in the cadmium sulfide layer can be greater than 0% to about 20%, such as about 1% to about 18%. In particular embodiments, the molar percentage of oxygen in the cadmium sulfide layer can be about 3% to about 16%, such as about 5% to about 15%. If more than about 20 molar % of oxygen is included in the cadmium sulfide layer, then the layer may become too insulating, and adversely affect the performance of the resulting photovoltaic device.

The oxygen can be supplied from oxygen gas present during the deposition of the cadmium sulfide layer. For example, when the cadmium sulfide layer is sputtered from a cadmium sulfide target, oxygen gas can be included in the sputtering atmosphere, such as at an oxygen concentration greater than 0% to about 20% by volume of the sputtering atmosphere (e.g., about 1% to about 18% by volume, or about 5% to about 15% by volume). The remaining percentage of the sputtering atmosphere may include inert gas(es), such as argon.

Sputtering deposition involves ejecting material from a target, which is the material source, and depositing the ejected material onto the substrate to form the film. DC sputtering generally involves applying a direct current to a metal target (i.e., the cathode) positioned near the substrate (i.e., the anode) within a sputtering chamber to form a direct-current discharge. The sputtering chamber can have a reactive atmosphere (e.g., an oxygen atmosphere, nitrogen atmosphere) that forms a plasma field between the metal target and the substrate. Other inert gases (e.g., argon, etc.) may also be present. The pressure of the reactive atmosphere can be between about 1 mTorr and about 20 mTorr for magnetron sputtering. The pressure can be even higher for diode sputtering (e.g., from about 25 mTorr to about 100 mTorr). When metal atoms are released from the target upon application of the voltage, the metal atoms deposit onto the surface of the substrate. For example, when the atmosphere contains oxygen, the metal atoms released from the metal target can form a metallic oxide layer on the substrate. The current applied to the source material can vary depending on the size of the source material, size of the sputtering chamber, amount of surface area of substrate, and other variables. In some embodiments, the current applied can be from about 2 amps to about 20 amps. Conversely, RF sputtering involves exciting a capacitive discharge by applying an alternating-current (AC) or radio-frequency (RF) signal between the target (e.g., a ceramic source material) and the substrate. The sputtering chamber can have an inert atmosphere (e.g., an argon atmosphere) which may or may not contain reactive species (e.g., oxygen, nitrogen, etc.) having a pressure between about 1 mTorr and about 20 mTorr for magnetron sputtering. Again, the pressure can be even higher for diode sputtering (e.g., from about 25 mTorr to about 100 mTorr).

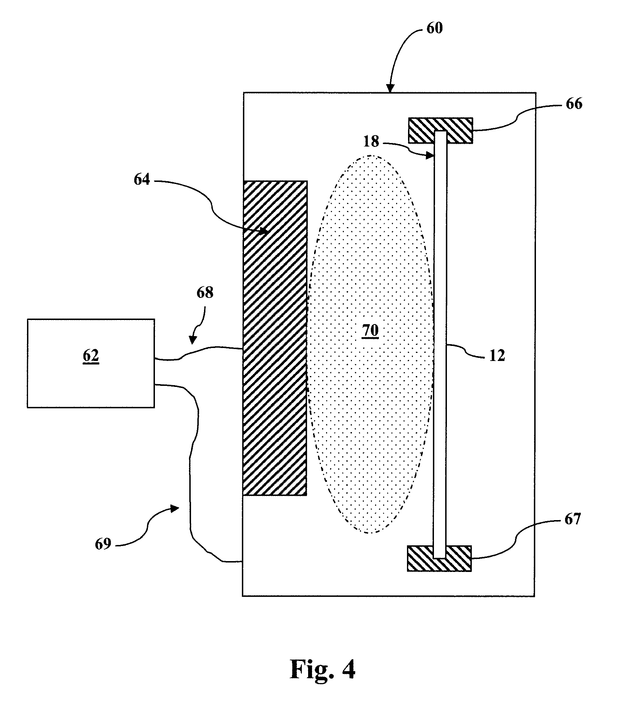

Fig. 4 shows a general schematic as a cross-sectional view of an exemplary DC sputtering chamber 60 according to one embodiment of the present invention. A DC power source 62 is configured to control and supply DC power to the chamber 60. As shown, the DC power source applies a voltage to the cathode 64 to create a voltage potential between the cathode 64 and an anode formed by the chamber wall, such that the substrate is in between the cathode and anode. The glass substrate 12 is held between top support 66 and bottom support 67 via wires 68 and 69, respectively. Generally, the glass substrate 12 is positioned within the sputtering chamber 60 such that the cadmium sulfide layer 18 is formed on the surface facing the cathode 64, and generally on the TCO layer 14 and RTB layer 16 (not shown) as discussed below.

A plasma field 70 is created once the sputtering atmosphere is ignited, and is sustained in response to the voltage potential between the cathode 64 and the chamber wall acting as an anode. The voltage potential causes the plasma ions within the plasma field 70 to accelerate toward the cathode 64, causing atoms from the cathode 64 to be ejected toward the surface on the glass substrate 12. As such, the cathode 64 can be referred to as a "target" and acts as the source material for the formation of the cadmium sulfide layer 18 on the surface of the glass substrate 12 facing the cathode 64. To form the cadmium sulfide layer, the cathode 64 can be a metal alloy target, such as of cadmium sulfide. Additionally, in some embodiments, a plurality of cathodes 64 can be utilized. A plurality of cathodes 64 can be particularly useful to form a layer including several types of materials (e.g., co-sputtering). Since the sputtering atmosphere contains oxygen gas, oxygen particles of the plasma field 70 can react with the ejected target atoms to form a cadmium sulfide layer 18 that includes oxygen.

Although only a single DC power source 62 is shown, the voltage potential can be realized through the use of multiple power sources coupled together. Additionally, the exemplary sputtering chamber 60 is shown having a vertical orientation, although any other configuration can be utilized. After exiting the sputtering chamber 60, the substrate 12 can enter an adjacent annealing oven (not shown) to begin the annealing process.

The presently provided methods of sputtering a cadmium sulfide layer including oxygen can be utilized in the formation of any film stack that utilizes a cadmium sulfide layer. For example, the cadmium sulfide layer including oxygen can be used during the formation of any cadmium telluride device that utilizes a cadmium telluride layer, such as in the cadmium telluride thin film photovoltaic device disclosed in U.S. Publication No. 2009/0194165 of Murphy, et al. titled "Ultra-high Current Density Cadmium Telluride Photovoltaic Modules."

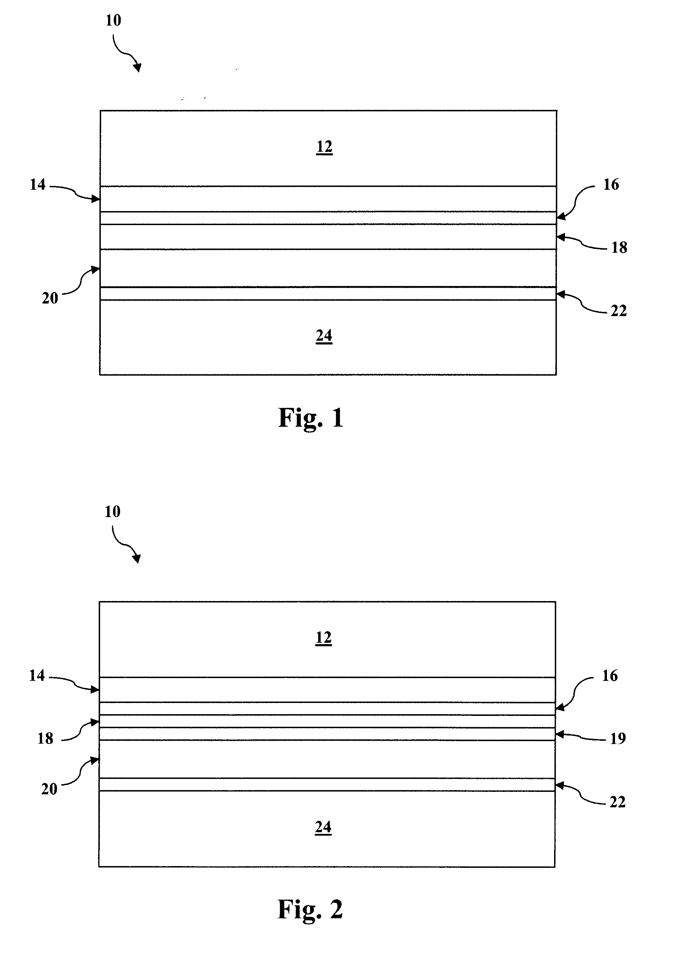

Fig. 1 represents an exemplary cadmium telluride thin film photovoltaic device 10 that can be formed according to methods described herein. The exemplary device 10 of Fig. 1 includes a top sheet of glass 12 employed as the substrate. In this embodiment, the glass 12 can be referred to as a "superstrate," as it is the substrate on which the subsequent layers are formed even though it faces upward to the radiation source (e.g., the sun) when the cadmium telluride thin film photovoltaic device 10 is in used. The top sheet of glass 12 can be a high-transmission glass (e.g., high transmission borosilicate glass), low-iron float glass, or other highly transparent material. The glass is generally thick enough to provide support for the subsequent film layers (e.g., from about 0.5 mm to about 10 mm thick), and is substantially flat to provide a good surface for forming the subsequent film layers. In one embodiment, the glass 12 can be a low iron float glass containing less than about 0.015% by weight iron (Fe), and may have a transmissiveness of about 0.9 or greater in the spectrum of interest (e.g., wavelengths from about 300 nm to about 900 nm). In another embodiment, borosilicate glass may be utilized so as to better withstand high temperature processing.

The transparent conductive oxide (TCO) layer 14 is shown on the glass 12 of the exemplary device 10 of Fig. 1. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). In certain embodiments, the TCO layer 14 can have a thickness between about 0.1 µm and about 1µm, for example from about 0.1 µm to about 0.5 µm, such as from about 0.25 µm to about 0.35 µm.

A resistive transparent buffer layer 16 (RTB layer) is shown on the TCO layer 14 on the exemplary cadmium telluride thin film photovoltaic device 10. The RTB layer 16 is generally more resistive than the TCO layer 14 and can help protect the device 10 from chemical interactions between the TCO layer 14 and the subsequent layers during processing of the device 10. For example, in certain embodiments, the RTB layer 16 can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.0 eV).

Without wishing to be bound by a particular theory, it is believed that the presence of the RTB layer 16 between the TCO layer 14 and the cadmium sulfide layer 18 can allow for a relatively thin cadmium sulfide layer 18 to be included in the device 10 by reducing the possibility of interface defects (i.e., "pinholes" in the cadmium sulfide layer 18) creating shunts between the TCO layer 14 and the cadmium telluride layer 22. Thus, it is believed that the RTB layer 16 allows for improved adhesion and/or interaction between the TCO layer 14 and the cadmium telluride layer 22, thereby allowing a relatively thin cadmium sulfide layer 18 to be formed thereon without significant adverse effects that would otherwise result from such a relatively thin cadmium sulfide layer 18 formed directly on the TCO layer 14.

The RTB layer 16 can include, for instance, a combination of zinc oxide (ZnO) and tin oxide (SnO₂) which can be referred to as a zinc tin oxide layer ("ZTO"). In one particular embodiment, the RTB layer 16 can include more tin oxide than zinc oxide. For example, the RTB layer 16 can have a composition with a stoichiometric ratio of ZnO/SnO₂ between about 0.25 and about 3, such as in about an one to two (1:2) stoichiometric ratio of tin oxide to zinc oxide. The RTB layer 16 can be formed by sputtering, chemical vapor deposition, spraying pryolysis, or any other suitable deposition method. In one particular embodiment, the RTB layer 16 can be formed by sputtering (e.g. DC sputtering or RF sputtering) on the TCO layer 14 (as discussed below in greater detail with respect to the deposition of the cadmium sulfide layer 18). For example, the RTB layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% pure oxygen, such as greater than about 99%.

In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm.

A cadmium sulfide layer 18 including oxygen is shown on RTB layer 16 of the exemplary device 10 of Fig. 1. The cadmium sulfide layer 18 is a n-type layer that generally includes cadmium sulfide (CdS) and oxygen, but may also include other materials, such as zinc sulfide, cadmium zinc sulfide, etc., and mixtures thereof as well as dopants and other impurities. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering (e.g., direct current (DC) sputtering or radio frequency (RF) sputtering) on the resistive transparent layer 16.

Due to the presence of the resistive transparent layer 16, the cadmium sulfide layer 18 can have a thickness that is less than about 0.1 µm, such as between about 10 µm and about 100 nm, such as from about 50 nm to about 80 nm, with a minimal presence of pinholes between the resistive transparent layer 16 and the cadmium sulfide layer 18. Additionally, a cadmium sulfide layer 18 having a thickness less than about 0.1 µm reduces any absorption of radiation energy by the cadmium sulfide layer 18, effectively increasing the amount of radiation energy reaching the underlying cadmium telluride layer 22.

Fig. 2 shows another exemplary device 10 having a second cadmium sulfide layer 19 on the cadmium sulfide layer 18 including oxygen. The second cadmium sulfide layer 19 can be included between the cadmium sulfide layer 18 including oxygen and the cadmium telluride layer 20 to improve the junction formed between the cadmium sulfide layer 18 including oxygen and the cadmium telluride layer 20.

In one particular embodiment, the second cadmium sulfide layer 19 can be substantially free from oxygen to inhibit the diffusion of oxygen into the cadmium telluride layer 20 from the cadmium sulfide layer 18 including oxygen. As used herein, the term "substantially free" means no more than an insignificant trace amount present and encompasses completely free (e.g., 0 molar % up to 0.0001 molar %). For instance, the cadmium sulfide layer 18 including oxygen can be sputtered from a first sputtering atmosphere including oxygen. Then, the second cadmium sulfide layer 19 can be sputtered in a second sputtering atmosphere substantially free from oxygen. For example, the second cadmium sulfide layer 19 can be sputtered from a ceramic target of cadmium sulfide in a sputtering atmosphere containing an inert gas (e.g., argon) without any oxygen present, such as consisting essentially of an inert gas (e.g., argon) or inert gasses. In one embodiment, the sputtering atmosphere can consist of argon for sputtering the second cadmium sulfide layer 19 on the cadmium sulfide layer 18 including oxygen.

When present, the second cadmium sulfide layer 19 can have a thickness of about 10 nm to about 100 nm (e.g., about 10 nm to about 50 nm), while the cadmium sulfide layer 18 including oxygen has a thickness of about 10 nm to about 100 nm (e.g., about 10 nm to about 50 nm).

In another embodiment, the second cadmium sulfide layer 19 can be composed from a plurality of layers, where each layer has a decreasing amount of oxygen in a direction away from the cadmium sulfide layer 18 including oxygen and toward the cadmium telluride layer 20. For example, Fig. 4 another an exemplary embodiment of a second cadmium sulfide layer 19 that includes a plurality of layers of decreasing oxygen content (layers 1-5, respectively) formed step-wise to collectively define the second cadmium sulfide layer 19. Each individual layer 1-5 has a decreasing oxygen content, such that layer 2 has less oxygen content than layer 1, layer 3 has less oxygen content than layer 2, layer 4 has less oxygen content than layer 3, and layer 5 has less oxygen content than layer 4. For instance, layer 1 can have an oxygen content of about 15 molar % to about 20 molar %; layer 2 can have an oxygen content of about 10 molar % to about 15 molar %; layer 3 can have an oxygen content of about 5 molar % to about 10 molar %; layer 4 can have an oxygen content of about 0.1 molar % to about 5 molar %; and, layer 5 can be substantially free from oxygen. Although the exemplary step-wise graded second cadmium sulfide layer 19 has five layers 1-5, any number of step-wise layers can be used to form the graded second cadmium sulfide layer 19. Additionally, each of the layers 1-5 can be formed of varying thickness, such as from about 1 nm to about 50 nm in thickness. In certain embodiments, the thickness of each of the layers 1-5 can be from about 5 nm to about 50 nm, for example from about 10 nm to about 30 nm. In one embodiment, each of the layers 1-5 can have substantially the same thickness.

Such a graded second cadmium sulfide layer 19 can be achieved by reducing the amount of oxygen in the sputtering atmosphere during sputtering in a single chamber or in a series of sequential chambers.

A cadmium telluride layer 20 is shown on the cadmium sulfide layer 18 in the exemplary cadmium telluride thin film photovoltaic device 10 of Fig. 1. The cadmium telluride layer 20 is a p-type layer that generally includes cadmium telluride (CdTe) but may also include other materials. As the p-type layer of device 10, the cadmium telluride layer 20 is the photovoltaic layer that interacts with the cadmium sulfide layer 18 (i.e., the n-type layer) to produce current from the absorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 2 µm and about 4 µm, such as about 3µm.

A series of post-forming treatments can be applied to the exposed surface of the cadmium telluride layer 20. These treatments can tailor the functionality of the cadmium telluride layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 424° C) for a sufficient time (e.g., from about 1 to about 10 minutes) to create a quality p-type layer of cadmium telluride. Without wishing to be bound by theory, it is believed that annealing the cadmium telluride layer 20 (and the device 10) converts the normally lightly p-type doped, or even n-type doped cadmium telluride layer 20 to a more strongly p-type cadmium telluride layer 20 having a relatively low resistivity. Additionally, the cadmium telluride layer 20 can recrystallize and undergo grain growth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride and then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, CdTeO₃, CdTe₂O₅, etc. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride (Cu₂Te) between the cadmium telluride layer 20 and the back contact layer 22. Thus, the Te-rich surface of the cadmium telluride layer 20 can enhance the collection of current created by the device through lower resistivity between the cadmium telluride layer 20 and the back contact layer 22.

Copper can be applied to the exposed surface of the cadmium telluride layer 20 by any process. For example, copper can be sprayed or washed on the surface of the cadmium telluride layer 20 in a solution with a suitable solvent (e.g., methanol, water, or the like, or combinations thereof) followed by annealing. In particular embodiments, the copper may be supplied in the solution in the form of copper chloride, copper iodide, or copper acetate. The annealing temperature is sufficient to allow diffusion of the copper ions into the cadmium telluride layer 20, such as from about 125° C to about 300° C (e.g. from about 150° C to about 200° C) for about 5 minutes to about 30 minutes, such as from about 10 to about 25 minutes.

A back contact layer 22 is shown on the cadmium telluride layer 20. The back contact layer 22 generally serves as the back electrical contact, in relation to the opposite, TCO layer 14 serving as the front electrical contact. The back contact layer 22 can be formed on, and in one embodiment is in direct contact with, the cadmium telluride layer 20. The back contact layer 22 is suitably made from one or more highly conductive materials, such as elemental nickel, chromium, copper, tin, aluminum, gold, silver, technetium or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 22, can be from about 0.1 µm to about 1.5 µm in thickness.

The encapsulating glass 24 is also shown in the exemplary cadmium telluride thin film photovoltaic device 10 of Fig. 1.

Other components (not shown) can be included in the exemplary device 10, such as bus bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

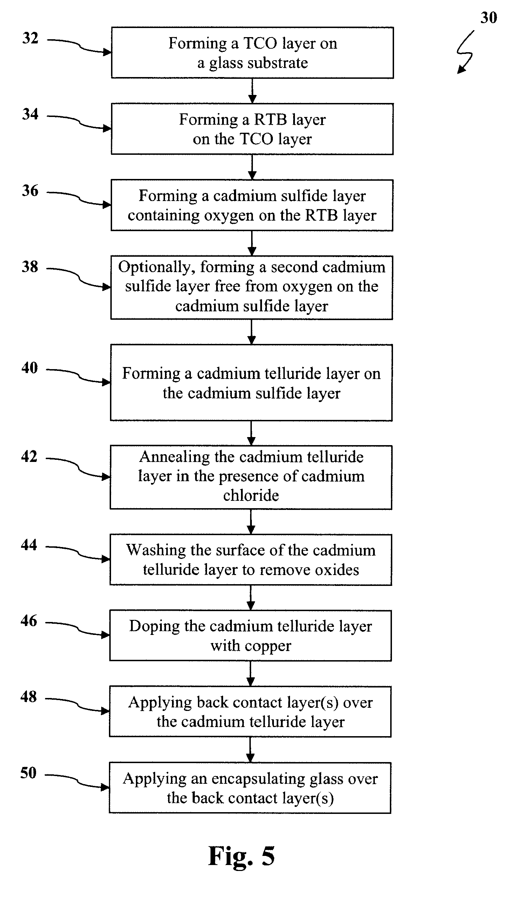

Fig. 5 shows a flow diagram of an exemplary method 30 of manufacturing a photovoltaic device according to one embodiment of the present invention. According to the exemplary method 30, a TCO layer is formed on a glass substrate at 32. At 34, a resistive transparent buffer layer is formed on the TCO layer. A cadmium sulfide layer containing oxygen is formed on the resistive transparent buffer layer at 36. Optionally, a second cadmium sulfide layer substantially free from oxygen is formed on the cadmium sulfide layer including oxygen at 38. A cadmium telluride layer is formed on the cadmium sulfide layer at 40. The cadmium telluride layer can be annealed in the presence of cadmium chloride at 42, and washed to remove oxides formed on the surface at 44. The cadmium telluride layer can be doped with copper at 46. At 48, back contact layer(s) can be applied over the cadmium telluride layer, and an encapsulating glass can be applied over the back contact layer at 50.

One of ordinary skill in the art should recognize that other processing and/or treatments can be included in the method 30. For instance, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

## Claims

1. A cadmium telluride thin film photovoltaic device 10, comprising:
a substrate 12;
a transparent conductive oxide layer 14 on the substrate 12;
a cadmium sulfide layer 18 on the transparent conductive oxide layer 14, wherein the cadmium sulfide layer 18 comprises oxygen in a molar percentage greater than 0 % to about 20 %;
a cadmium telluride layer 20 on the cadmium sulfide layer 18; and,
a back contact layer 22 on the cadmium telluride layer 20.

2. The device 10 as in claim 1, wherein the cadmium sulfide layer 18 comprises oxygen in a molar percentage of about 1 % to about 18 %, preferably about 5 % to about 15 %.

3. The device 10 as in claim 1 or 2, further comprising:
a second cadmium sulfide layer 19 between the cadmium sulfide layer 18 and the cadmium telluride layer 20, wherein the second cadmium sulfide layer is substantially free from oxygen.

4. The device 10 as in claim 3, wherein the second cadmium sulfide layer 19 consists of cadmium sulfide.

5. The device 10 as in claim 3 or 4, wherein the second cadmium sulfide layer 19 has a thickness of about 10 nm to about 100 nm.

6. The device 10 as in claim 1 or 2, further comprising:
a second cadmium sulfide layer 19 comprising a plurality of layers, where each layer has a decreasing amount of oxygen in a direction away from the cadmium sulfide layer 18 and toward the cadmium telluride layer 20.

7. The device 10 as in any preceding claim, wherein the cadmium sulfide layer 18 comprises oxygen in a graded concentration that decreases in a direction from the transparent conductive oxide layer 14 to the cadmium telluride layer 20.

8. The device 10 as in any preceding claim, further comprising:
a resistive transparent buffer layer 16 between transparent conductive oxide 14 layer and the cadmium sulfide layer 18.

9. A method of depositing a cadmium sulfide layer 18 on a substrate, the method comprising:
sputtering a cadmium sulfide layer 18 on a substrate 12 from a target 64 in a sputtering atmosphere, wherein the target 64 comprises cadmium sulfide, and wherein the sputtering atmosphere comprises an inert gas and oxygen in an amount of greater than 0% to about 20% by volume, preferably in the amount of about 2% to about 15% by volume.

10. The method as in claim 9, wherein the sputtering atmosphere has a sputtering pressure of about 10 mTorr to about 150 mTorr.

11. The method as in claim 9 or 10, further comprising:
sputtering a second cadmium sulfide layer 19 on the cadmium sulfide layer 18 in a second sputtering atmosphere, wherein the second sputtering atmosphere is substantially free from oxygen.

12. The method as in any of claims 9 to 11, wherein the second sputtering atmosphere consists essentially of an inert gas.

13. The method as in any of claims 9 to 12, wherein the amount of oxygen in the sputtering atmosphere is decreased during sputtering such that the cadmium sulfide layer 18 has a graded concentration of oxygen that decreases in a direction away from the substrate.

14. The method as in any of claims 9 to 13, further comprising:
sputtering a second cadmium sulfide layer 19 comprising a plurality of layers, where each layer has a decreasing amount of oxygen in a direction away from the substrate.

15. A method of manufacturing a cadmium telluride thin film photovoltaic device 10, the method comprising:
depositing a resistive transparent buffer layer 16 on a transparent conductive oxide layer 14, wherein the transparent conductive oxide layer 14 is on a substrate 12;
sputtering a cadmium sulfide layer 18 on the resistive transparent buffer layer 16 according to the method of any of claims 9 to 14; and,
depositing a cadmium telluride layer 20 on the cadmium sulfide layer 18.
